# FASCICULE DE BREVET EUROPEEN

(11) **EP 1 923 912 B1**
(45) Date de publication et mention de la délivrance du brevet: **08.05.2019**
(21) Numéro de dépôt: 07291102.7
(22) Date de dépôt: 14.09.2007
(51) Int. Cl.: H01L 21/762

(54) **Procédé de fabrication d'une structure microtechnologique mixte**
Verfahren zur Herstellung einer gemischten mikrotechnologischen Struktur
Method of manufacturing a mixed microtechnology structure

(30) Priorité: 19.09.2006 FR 0653820
(43) Date de publication de la demande: 21.05.2008
(73) Titulaire: Commissariat à l'Énergie Atomique et aux Énergies Alternatives, 75015 Paris (FR)
(72) Inventeur: Kostrzewa, Marek, 38100 Grenoble (FR); Moriceau, Hubert, 38120 Saint-Egreve (FR); Zussy, Marc, 38120 Saint Egreve (FR)
(74) Mandataire: Colombo, Michel

(56) Documents cités:
- EP-A- 1 398 825
- EP-A- 1 398 829
- WO-A-2005/083775
- FR-A- 2 876 220
- US-B1- 6 191 007

## Description

### Domaine technique.

L'invention concerne la fabrication d'une structure micro-technologique mixte, c'est-à-dire d'un substrat (ou d'un ensemble de substrats et/ou de couches) réalisé par des moyens utilisés classiquement en microélectronique et pouvant comporter notamment des composants microélectroniques et/ou optiques et/ou mécaniques....

Depuis environ une dizaine d'années, on a pu observer un développement important de circuits intégrés qui ne sont plus de simples circuits électroniques : il est ainsi prévu que ces nouveaux circuits intégrés, qui sont déjà en développement, contiennent des fonctions optiques, des fonctions de haute fréquence, voire même des fonctions moléculaires et bioélectroniques (on utilise couramment la dénomination de SOC, qui correspond à **S**ystem **O**n **C**hip). Toutefois, il y a de nombreuses applications où il est difficile ou même impossible de réaliser tous les circuits ou composants assurant ces différentes fonctions sur un même substrat microtechnoloqique homogène, par un seul enchaînement d'étapes technologiques.

Une solution simple a consisté à fabriquer les composants sur des substrats séparés et à ensuite les rassembler un par un sur un même substrat formant support au moyen d'un collage par apport de matière, par exemple au moyen d'un matériau métallique ou époxy, selon la technique de retournement dite « flip-chip » ou autre, etc. Cette solution est satisfaisante pour un certain nombre d'applications mais ne permet pas, notamment, la miniaturisation de circuits intégrés à grande échelle.

Une autre solution a consisté à prévoir des substrats non plus homogènes mais présentant des zones ayant des propriétés différentes permettant la réalisation de composants différents.

Cela explique que, pour certaines applications, et plus particulièrement pour l'intégration au sein d'une structure de composants dits « verticaux » conjointement avec des composants totalement isolés, il a été proposé de réaliser un substrat mixte (ou « patterné », c'est-à-dire présentant une couche mixte enterrée présentant des motifs de matériaux différents), c'est-à-dire un substrat au sein duquel deux types de zones coexistent :
- des zones ayant les propriétés d'un matériau massif entre les faces du substrat (pour les composants « verticaux »)
- des zones de type SOI (**S**ilicon **O**n **I**nsulator, c'est-à-dire comportant du silicium au dessus d'un isolant, tel qu'un oxyde).

Les matériaux massifs assurent une meilleure conduction électrique (entre la face avant et la face arrière du substrat), de même que, compte tenu de l'absence de toute barrière thermique significative, ils assurent une meilleure conductivité thermique (donc une bonne dissipation de la chaleur) que les substrats ou les zones de type SOI. Ils sont donc tout à fait appropriés, notamment, pour la fabrication de composants « verticaux » (composants de puissance notamment).

Les zones SOI ont par contre l'avantage de permettre de réaliser des composants totalement isolés, tels que des transistors MOS de type totalement déserté (Fully Depleted MOS) et d'autres composants microélectroniques (notamment des circuits logiques), par exemple.

Des tels substrats mixtes présentent en principe de nombreux avantages, pour de nombreuses applications parmi lesquelles on peut citer, en particulier :
- intégration de mémoires DRAM sur un substrat comportant des zones SOI (le fonctionnement dynamique des mémoires DRAM sur un substrat SOI est perturbé par le potentiel flottant de ce substrat SOI, de sorte qu'il est préférable de réaliser ces mémoires dans des zones massives à côté de zones SOI).
- intégration de composants de puissance sur SOI (l'intégration de composants sur des substrats SOI n'est pas possible à cause de l'architecture de ces composants (c'est notamment le cas des composants VDMOS, correspondant à « Vertical Double-diffused Metal Oxide Semiconductor), d'autant que la couche d'isolant d'un substrat SOI serait une barrière thermique qui empêcherait une dissipation suffisante de la chaleur générée au coeur du composant),
- intégration de MEMS et de nouvelles architectures de composants pour la fabrication de capteurs, circuits optoélectroniques, etc.

En fait, de tels substrats mixtes peuvent être réalisés par oxydation de zones enterrées, ou par formation de motifs oxydes à la surface d'un substrat sur lequel on colle ensuite un autre substrat.

Le collage direct (souvent appelé collage moléculaire ou « direct bonding » en anglais) est particulièrement bien adapté à cet effet, puisque ce collage est capable en principe d'assurer une très bonne tenue mécanique, une bonne conductivité thermique, une uniformité d'épaisseur de l'interface de collage, etc. Ce collage est réalisé sans apport de matière (donc sans adhésif). Une simple préparation de surface peut suffire en principe pour assurer un tel collage (elle peut toutefois être délicate), même à la température ambiante. La mise en contact des surfaces à coller est généralement suivie d'un traitement thermique de renforcement (ou de consolidation).

Plus précisément, il est connu que le collage direct permet de reporter des couches minces sur un substrat. Une des étapes-clés lors d'un tel report d'une couche mince sur un substrat est en pratique le couple (mise en contact des surfaces) + (traitement thermique de renforcement de l'interface de collage). En effet, lors de ce traitement thermique, des défauts de collage peuvent apparaître sous forme de zones non collées : ces défauts peuvent se traduire par exemple par l'apparition de précipités d'oxyde natif ou/et de molécules de gaz enfermées lors de la mise en contact des deux plaquettes (à savoir la couche et le substrat) pouvant être en silicium (ou en un autre matériau).

Il est à noter que, d'après le document WO - 2004/059711 (Fournel et al.) concernant la production de structures mixtes, la présence de pavés d'oxyde à l'interface de collage peut servir de pièges aux impuretés et les adsorber lors du traitement thermique de consolidation du collage.

Il peut être noté ici que, pour certaines applications, on peut chercher à reporter une couche de silicium sur un substrat du silicium, non pas directement mais via une couche d'oxyde fin. Conformément au document WO - 2004/059711 précité, lors du traitement thermique, les impuretés emprisonnées lors de la mise en contact peuvent être adsorbées par la couche d'oxyde. Néanmoins, si cette couche est très fine, elle ne peut pas adsorber la totalité des différentes impuretés, et des défauts de collage apparaissent tout de même sous forme de zones non collées. Par contre, on comprend que la coexistence dans un substrat de zones de type SOI présentant des épaisseurs d'oxyde différentes pourrait résoudre le problème de dégazage des impuretés, en augmentant l'épaisseur de la couche d'oxyde là où cela n'est pas gênant pour les composants. Cela correspond à un autre type de structure mixte.

On comprend ainsi l'intérêt qu'il peut y avoir à savoir réaliser, notamment, deux types de structures (ou substrats) dites « patternées », ou mixtes:
- substrat SOI partiel (coexistence de zones SOI et de zones massives),
- substrat SOI mixte (coexistence de deux types de zones SOI, avec des épaisseurs différentes d'oxydes enterrés).

En fait, ces deux types diffèrent par la présence, ou non, d'une couche d'oxyde continue entre les parties supérieure et inférieure de la structure.

On comprend aisément, en outre, l'intérêt qu'il peut à y avoir à pouvoir modifier d'autres caractéristiques du substrat mixte décrit ci-dessus :
- possibilité d'employer différents matériaux (SiO2 thermique et/ou déposé, Si3N4, Al2O3, AIN et d'autres matériaux isolants) en tant qu'isolant enterré ;
- possibilité d'utiliser d'autres matériaux (Si, mais aussi SiGe, GaAs, GaN, InP et d'autres matériaux) de part et d'autre de la couche, continue ou non, d'isolant enterré, en particulier pour la couche reportée et pour le substrat sur lequel cette couche est collée (lorsque la structure est obtenue par collage direct).

Plus généralement, il peut être intéressant d'obtenir une structure mixte, c'est-à-dire présentant une couche enterrée composée de zones de matériaux différents permettant de modifier localement les propriétés électriques et/ou thermiques et/ou mécaniques et/ou optiques et/ou chimiques de la structure.

### Etat de l'art

Comme indiqué ci-dessus, il existe différentes technologies pour réaliser des SOI mixtes ou partiels notamment par oxydation sous la surface d'un substrat, ou par collage (en pratique direct) de plusieurs couches ou substrats.

### Technologie SIMOX par implantation locale

Le procédé SIMOX (pour **S**éparation by **IM**plantation of **OX**ygen, c'est-à-dire une séparation par implantation d'oxygène) est connu pour sa simplicité dans la production de substrats SOI. Afin d'obtenir un substrat SOI, une dose très lourde d'oxygène est implantée au-dessous de la surface dite « supérieure » d'une plaquette (ou substrat) de silicium, puis l'ensemble est recuit à une température élevée pour convertir la région implantée en oxygène en dioxyde de silicium SiO2.

Cette technologie peut permettre la réalisation de substrats mixtes : en utilisant les techniques connues de masquage et de lithographie, il est en effet possible d'implanter les ions oxygène de façon localisée, et par cette voie créer des couches localisées d'oxydes sous- jacents (voir les documents US - 2006/0040476, US - 6 846 727 ou l'article « Fabrication of High Quality Patterned SOI Materials by Optimized Low-Dose SIMOX » de Dong et al., pages 60-61 in «2004 IEEE International SOI Conférence 2004 »).

La fabrication d'un substrat (ou structure) patterné(e) en utilisant le procédé SIMOX consiste ainsi à :
- déposer un masque dur sur un substrat,
- ouvrir dans ce masque des fenêtres d'implantation (par lithographie)
- implanter des ions d'oxygène au travers de ces fenêtres,
- effectuer un recuit d'oxydation en sorte de former des zones localisées d'oxyde enterré
- éliminer ce masque.

Ce procédé est néanmoins limité, en terme de choix de matériaux et ne permet pas de réaliser des structures hybrides (Germanium sur Silicium, GaN sur Silicium, Silicium sur verre, etc.) ou en terme de structure cristallographique (par exemple des couches amorphes). En fait, seule la formation du dioxyde de silicium a été bien étudiée, même si des tests avec une implantation d'azote ont permis de vérifier la formation de nitrure de silicium.

Cette approche présente par ailleurs divers inconvénients ou difficultés :
- choix d'oxyde limité : SiO2 par implantation d'oxygène et SiN par implantation d'azote, alors que bien d'autre matériaux peuvent être souhaités,
- choix de matériau limité pour l'ensemble de la structure où les motifs d'isolant sont formés (silicium, en pratique),
- déformations en surface après l'implantation et après le recuit d'oxydation (l'oxydation implique une augmentation locale du volume des zones où l'oxygène se combine avec le silicium, et par conséquent des « gonflements en surface »),
- présence de transitions entre les zones SOI et les zones massives présentant une densité élevée de défauts,
- grande difficulté à obtenir de manière bien contrôlée des structures de type SOI mixte (c'est-à-dire des substrats de type SOI avec une couche d'oxyde dont l'épaisseur varie d'une zone à l'autre).

Une approche plus exploratoire a été proposée par Terada et al. (« A New DRAM Cell with a Transistor on a Lateral Epitaxial Silicon Layer (TOLE Cell) », pages 20522057, in IEEE Transactions on Electron Devices Vol 37, N°7, september 1990 »). Selon ce document, une couche d'oxyde thermique est formée sur un substrat de silicium ; des étapes de la lithographie sont réalisées afin de graver localement la couche de l'oxyde ; une reprise d'épitaxie latérale est ensuite effectuée ; un polissage final permet d'enlever le silicium et de planariser la surface. Cependant, le choix des matériaux pour réaliser cette structure est limité (pour permettre la compatibilité nécessaire pour la reprise d'épitaxie). Les épaisseurs mises en jeu sont également limitées, notamment lorsque la structure est hétérogène.

### Substrats SOI mixtes ou partiels obtenus par collage direct.

Le principe de la production de structures mixtes par collage direct est notamment décrit dans le document WO - 2004/059711 précité, mais aussi dans le document US - 5 691 231 dont le préambule présente diverses solutions connues, ou encore dans l'article « Dielectric Isolation Technologies and Power ICs » de Y. Sugawara dans « Smart Power ICs » de Muvavi, Bevotti et Vignola.

On commence par créer une cavité dans un substrat de silicium puis on oxyde l'ensemble de la surface. Un polissage mécano-chimique (**C**hemical **M**echanical **P**olishing) permet d'enlever une partie de l'oxyde et exposer à la fois des zones Si et des zones SiO2, en sorte d'obtenir une surface mixte. Après un nettoyage chimique, un autre substrat de silicium est collé sur cette surface mixte et ensuite aminci, ce qui aboutit au substrat mixte souhaité. On peut ensuite former des tranchées pour compléter l'isolation d'une zone de substrat longeant la couche locale d'isolant.

Selon une variante mentionnée par Sugawara (voir ci-dessus), on peut former une zone dopée (par implantation) au fond de la cavité avant de la remplir par oxydation.

Ces approches se heurtent à une difficulté majeure qui est liée au polissage de la surface mixte formée par les zones mixtes Si/SiO2 : la présence conjointe de zones Si et SiO2 coexistant en surface rend difficile une planarisation de surface permettant un bon collage direct, alors qu'on comprend aisément que, dans tous les cas où on veut réaliser un collage direct, la planéité est essentielle et que la qualité du polissage est critique.

Or il n'existe pas aujourd'hui de procédé de polissage d'une surface mixte présentant à la fois des zones de silicium et d'oxyde de silicium permettant d'obtenir une surface compatible (notamment en terme de planéité, de rugosité et d'homogénéité du caractère hydrophile) avec un collage direct de bonne qualité.

En général, la vitesse de polissage de l'oxyde de silicium est inférieure à celle du silicium. On obtient alors un phénomène dit de « dishing » correspondant à la formation d'une dénivellation négative (évoquant un plat (« dish » en anglais)) au niveau des zones en silicium. Il peut également persister en surface des dénivellations positives (on obtient des monticules) liées à un défaut d'efficacité du polissage par exemple. Cette dénivellation négative ou positive peut atteindre des dizaines de nanomètres en fonction notamment des conditions de polissage et de la taille des plots d'oxyde ou/et des plots de silicium. Dans le deux cas, les irrégularités de surface peuvent ne pas permettre de réaliser un collage direct de très bonne qualité et le rendement de production de tels ensembles collés peut être très faible.

Moriceau et al. ont, dans l'article « Transfer of patterned Si and SiO2 layers for the fabrication of Patterned and Mixed SOI » pp 203-204, in « 2004 IEEE International SOI Conference, 10/04, commenté ce problème de polissage tout en affirmant qu'il était possible de résoudre le problème de dénivellation, peu sensible à l'échelle submicronique mais couramment observable dans le cas de motifs ayant des dimensions de l'ordre du micron voire du millimètre, en optimisant les procédés de polissage pour chaque configuration du substrat mixte (répartition des motifs formés par les plots, taille de plots, épaisseur d'oxyde etc.). Mais cela implique qu'il n'est pas toujours possible d'éviter ces problèmes de polissage si l'on ne peut pas jouer sur les divers paramètres précités.

Pour la fabrication d'une structure mixte comportant un composant vertical et son circuit de commande, Hiromasa et al., dans le document JP - 08-330554, a préconisé que, dans la cavité, la couche d'oxyde de silicium soit en retrait par rapport à la surface de silicium, en notant qu'ainsi il n'y a pas de défauts de collage dans la zone du composant vertical. Mais il est clair que, dans cette approche, l'interface de collage n'est pas continue, de sorte que les molécules de gaz peuvent être piégées après la mise en contact des deux plaquettes. Cela a pour inconvénient que ces molécules peuvent conduire à la séparation partielle et involontaire de la couche reportée. Le manque de continuité conduit par ailleurs notamment à une faible conductivité thermique de l'ensemble.

Pour s'affranchir de l'impact de dénivellation créé lors du polissage sur la qualité du collage d'une structure mixte, il a été proposé par le document US - 5 691 231 précité d'utiliser une couche de silicium polycristallin après la formation d'un oxyde. Dans un premier temps, des cavités remplies d'oxyde sont formés à la surface d'un substrat de silicium. L'ensemble est ensuite poli. Une couche de polysilicium est ensuite déposée sur la surface mixte planarisée puis polie. On y colle un autre substrat, puis on amincit le substrat de départ jusqu'à l'épaisseur finale voulue (typiquement de quelques microns).

Il est possible dans cette approche d'utiliser des substrats de silicium ayant des propriétés différentes (en terme de dopage par exemple). Néanmoins Ces couches restent séparées par une couche de polysilicium, ce qui peut être gênant pour certaines applications.

Une autre solution relative au collage direct a été également mentionnée dans le document précité de Sugawara (proposée par Ohata et al. dans Tech of IEEE Costume IC Conference, p443 (1986)). Dans cette approche, on dépose un masque de lithographie sur un substrat de type SOI après une étape de collage direct ; la couche supérieure de silicium, l'oxyde et le substrat massif en silicium (en partie) sont ensuite gravés pour former une cavité. Une reprise d'épitaxie du silicium est ensuite réalisée, avec une épaisseur supérieure à l'épaisseur de la cavité. Etant donné que la reprise d'épitaxie se fait aussi sur la couche supérieure de silicium, un polissage CMP est effectué afin d'éliminer cette surépaisseur formée sur la zone SOI. On comprend toutefois que cette technologie est complexe et d'application limitée. De l'état de la technique est également connu de : FR2876220A, EP1398829A, US6191007B1, WO20051083775 et EP1398825A.

### Probleme technique et solution apportée par l'invention

On constate ainsi, au vu de l'état de l'art présenté ci-dessus, qu'il n'existe pas une approche « universelle » permettant de réaliser des substrats mixtes ou « patternés », c'est-à-dire présentant une couche mixte enterrée avec des motifs de matériaux différents et notamment dont l'un au moins soit un matériau cristallin, ayant les performances suivantes :
- possibilité de mettre différents matériaux au niveau, au-dessus et en dessous de cette couche mixte,
- possibilité de gérer des épaisseurs différentes (et plus particulièrement possibilité d'obtenir des couches minces),
- possibilité de réaliser en même temps sur le même substrat de motifs micro- et millimétriques.

L'invention propose à cet effet un procédé de fabrication d'une structure mioro-technologique mixte conforme à la revendication 1.

l'invention proposé ainsi d'utiliser une couche sacrificielle d'arrêt de gravure (par exemple en Si3N4 ou autre) lors de la fabrication d'un substrat patterné. Cette couche permet de supprimer l'étape de polissage ou au moins d'éliminer l'effet de dénivellation et permet donc un très bon collage au niveau de la surface mixte mise à nue lorsqu'on enlève la couche sacrificielle.

Selon des caractéristiques préférées de l'invention, éventuellement combinées :
- l'un au moins des premier ou deuxième matériau est monocristallin,
- le premier matériau est électriquement non isolant,
- le deuxième matériau est électriquement isolant,
- le troisième matériau est électriquement non isolant,
- les premiers motifs et la couche continue de recouvrement contiennent un même élément, ce qui est particulièrement simple, même si, en variante, ces matériaux peuvent être différents, selon ce qui est souhaité ; c'est ainsi qu'il peut s'agir de silicium, ou au contraire d'autres éléments (par exemple germanium, alliages SiGe, alliages (III-V) comme AsGa, et autres éléments utiles dans le domaine des micro-technologies)
- la couche continue de recouvrement et les premiers motifs contiennent des dopages différents, au sein de matériaux identiques ou différents (voir ci-dessus),
- les seconds motifs sont en oxyde, ce qui correspond à un type d'isolant dont la production est bien maîtrisée ; de manière avantageuse, les seconds motifs contiennent un oxyde d'un élément contenu dans les premiers motifs, ce qui garantit notamment une bonne compatibilité chimique ; à titre d'exemple avantageux, cet oxyde est un oxyde de silicium
- la couche sacrificielle est un nitrure, ce qui correspond également à un composé dont la production est bien maîtrisée ; de manière préférée, la couche sacrificielle et les seconds motifs comportent respectivement un nitrure et un oxyde d'un même élément que comportent les premiers motifs de la couche mixte,
- la couche de recouvrement est en un même matériau que les premiers motifs,
- les premiers motifs sont en silicium (mais en variante bien d'autres éléments utiles en micro-technoloqie peuvent être utilisés),
- avant de réaliser la couche continue de recouvrement sur la surface mixte, on forme sur cette surface mixte ou sur cette couche continue de recouvrement une couche isolante d'interface ; on obtient ainsi une structure micro-technologique mixte du type SOI mixte ; de manière avantageuse, l'on forme la couche isolante d'interface par oxydation de surface de la couche continue de recouvrement ; de manière encore plus préférée, la couche isolante d'interface et les seconds motifs sont formés d'oxydes d'un même élément ; à titre d'exemple d'intérêt particulier, les premiers motifs sont en silicium et les oxydes de la couche isolante d'interface et des seconds motifs sont en oxydes de silicium.

De manière tout à fait avantageuse, on réalise ledit substrat provisoire à partir d'un substrat de départ comportant la couche sacrificielle et une couche préliminaire continue formée du premier matériau selon les étapes suivantes :
- on creuse par lithographie des cavités dans cette couche préliminaire à partir d'une face de cette couche qui est opposée à la couche sacrificielle, ces cavités s'étendant jusqu'à la couche sacrificielle,
- on remplit ces cavités avec un second matériau en sorte de former les seconds motifs et d'obtenir une surface mixte, cette couche préliminaire étant devenue ladite couche mixte,
- on forme sur cette surface mixte une couche de matériau de planarisation,
- on polit cette couche de matériau de planarisation en sorte d'avoir une surface continue plane, et
- on assemble à cette couche préliminaire, recouverte de ladite couche de planarisation, un substrat de support en un quatrième matériau, ce substrat de support ayant une surface collée par collage direct à la surface continue plane de la couche de planarisation

Selon des caractéristiques préférées de ce cas particulier de l'invention, éventuellement combinées :
- le substrat de départ comporte en outre un substrat de support intermédiaire, ce qui facilite les manipulations ; de manière avantageuse, le substrat de départ comporte en outre une couche isolante entre le substrat de support intermédiaire et la couche sacrificielle, ce qui peut se révéler faciliter l'élimination ultérieure de cette couche sacrificielle ; à titre d'exemple préféré, cette couche isolante est en un oxyde d'un élément de la couche du substrat de support intermédiaire, par exemple en SiO2,
- il y a une étape d'implantation de ce substrat de support intermédiaire avec des ions ou des espèces gazeuses en vue de former dans ce substrat de support intermédiaire une couche fragilisée le long d'une couche parallèle à la couche sacrificielle ; dans ce cas, de manière avantageuse, après assemblage par collage du substrat de support final avec la couche préliminaire, on provoque la séparation du substrat de support intermédiaire le long de la couche fragilisée,
- la couche préliminaire continue est obtenue par collage sur la couche sacrificielle d'un substrat préliminaire dont on provoque la séparation le long d'une couche de fragilisation,
- on remplit les cavités par exemple par dépôt sous forme vapeur,
- on obtient la surface mixte en polissant ce second matériau jusqu'à mettre à nu des portions de cette couche préliminaire entre les cavités,
- la couche de planarisation est par exemple une couche polycristalline d'un matériau que comportent les premiers motifs ; de manière préférée, cette couche polycristalline est déposée sous forme vapeur ; en variante, cette couche de planarisation est une couche métallique, avantageusement déposée par une technique d'évaporation ou de pulvérisation ou de dépôt en phase vapeur,
- le substrat de support final est en un matériau que comportent les premiers motifs.

Bien que non revendiqué sous la forme d'une revendication de structure,
cette structure ne faisant pas partie de l'invention,
il est également décrit par la suite une structure mixte obtenue par le procédé précité, dans le cas particulier où on forme la couche mixte par remplissage de cavités obtenues par lithographie et assemblage à un support par l'intermédiaire d'une couche de planarisation, cette structure étant reconnaissable par le fait que c'est une structure micro-technologique mixte comportant :
- un substrat de support,
- une couche de planarisation adjacente à ce substrat de support en lui étant collée par collage direct,
- une couche mixte comportant de premiers motifs en un premier matériau et de seconds motifs en un deuxième matériau différent du premier matériau, cette couche mixte longeant cette couche de planarisation,
- une couche de recouvrement assemblée au moins indirectement à cette couche mixte par un collage direct.

Selon des caractéristiques préférées découlant de celles mentionnées ci-dessus, on peut citer les suivantes :
- le premier matériau est électriquement non isolant,
- le deuxième matériau est électriquement isolant
- la couche de recouvrement est reliée à la couche mixte par l'intermédiaire d'une couche isolante d'interface,
- les motifs isolants sont en oxyde,
- il y a une différence de dopage entre les seconds motifs de la couche mixte et la couche continue de recouvrement.

### Description de l'invention

Des objets, caractéristiques et avantages de l'invention ressortent de la description qui suit, donnée à titre d'exemple illustratif non exhaustif, en regard des dessins sur lesquels :
- la figure 1 est une vue schématique en coupe d'une première étape de fabrication d'une structure selon l'invention, mettant en oeuvre un substrat de départ par exemple en silicium,
- la figure 2 est une vue schématique d'une seconde étape de fabrication, mettant en oeuvre une gravure,
- la figure 3 est une vue schématique d'une troisième étape de fabrication, mettant en oeuvre un dépôt par exemple d'oxyde,
- la figure 4 est une vue schématique d'une quatrième étape de fabrication, mettant en oeuvre un polissage,
- la figure 5 est une vue schématique d'une cinquième étape de fabrication, mettant en oeuvre le dépôt d'une couche de planarisation, par exemple en silicium polycristallin,
- la figure 6 est une vue schématique d'une sixième étape de fabrication, mettant en oeuvre un collage direct,
- la figure 7 est une vue schématique d'une septième étape de fabrication, mettant en oeuvre une attaque sélective,
- la figure 8 est une vue schématique d'une huitième étape de fabrication, aboutissant à une structure mixte,
- la figure 9 est une vue schématique d'une sous-étape optionnelle de la huitième étape de fabrication, mettant en oeuvre un collage direct et une fragilisation par implantation,
- la figure 10 est une vue schématique d'une autre structure mixte, et
- la figure 11 est une vue schématique d'encore une autre structure mixte.

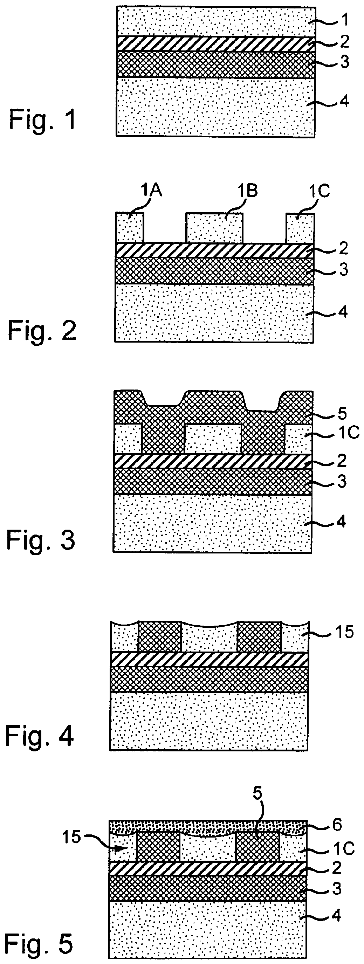

Dans le cas particulier des figures 1 à 8, le procédé de l'invention comporte les étapes suivantes, illustrées pour certains exemples de matériaux (non limitatifs) :
- a) fabrication d'un substrat adapté aux futurs besoins comportant une couche sacrificielle 2, par exemple de nitrure disposée entre une couche préliminaire 1 (avantageusement formée d'un matériau monocristallin, par exemple de silicium) et un substrat de départ (pouvant lui-même comporter, du côté de la couche sacrificielle, une couche isolante 3, par exemple d'oxyde) ; la couche sacrificielle 2 peut avantageusement présenter au niveau de son interface avec la couche préliminaire 1 une sélectivité de gravure par rapport à cette couche ; elle peut également avantageusement présenter au niveau de son interface avec le substrat de départ une sélectivité de gravure par rapport à ce substrat,
- b) lithographie et gravure sélective de la couche préliminaire 1 jusqu'à atteindre la couche sacrificielle 2, laissant subsister des plots de la couche préliminaire dits plots d'intérêt 1A, 1B, 1C,
- c) remplissage par une couche de remplissage 5 des zones de surfaces situées entre les plots d'intérêt 1A, 1B, 1C pour au moins atteindre le niveau de surface de ces plots, avantageusement par un matériau isolant, par exemple de l'oxyde de silicium
- d) polissage de la surface de la couche de remplissage 5, au moins jusqu'à atteindre les plots d'intérêt 1A, 1B, 1C, laissant subsister une couche mixte 15 sur la couche sacrificielle 2
- e) dépôt sur la couche mixte 15 d'une couche mince de planarisation 6 avantageusement non isolante par exemple en silicium polycristallin ou en métal et planarisation (CMP) de cette couche 6,
- f) collage sur la couche de planarisation 6 d'une seconde plaque 7 (par exemple de silicum) appelée substrat de support,
- g) élimination du substrat de départ et de la couche sacrificielle 2, mettant à nu une face de la couche mixte 15,
- h) report sur la face mise à nu de la couche mixte 15 d'une couche mince 9B (par exemple de silicium) appelée couche de recouvrement,

En variante, il est possible, notamment si la couche préliminaire est en silicium, avantageusement recouvert d'une couche mince de nitrure, de ne graver localement à l'étape b) qu'une partie de l'épaisseur de cette couche préliminaire de silicium, l'épaisseur résiduelle étant ensuite consommée par oxydation thermique. L'étape c) peut dans ce cas, devenir facultative si l'oxydation thermique suffit à remplir les zones de surface situées entre les plots d'intérêt. La couche mince de nitrure de la couche préliminaire pourra, si souhaité, être sélectivement enlevée par exemple après l'étape d'oxydation thermique.

Dans une autre variante, à l'étape c), la couche de remplissage 5 assurant le remplissage des zones de surfaces situées entre les plots d'intérêt 1A, 1B, 1C peut ne pas atteindre le niveau de surface de ces plots : dans ce cas, l'étape d) de polissage n'est pas utile.

Avantageusement, pour ce procédé, on choisira de mettre en oeuvre des matériaux permettant d'utiliser des attaques chimiques à forte sélectivité pour le retrait de la couche sacrificielle.

La couche de planarisation 6 permet « d'absorber » la topologie de surface de la couche mixte 15. Cette topologie peut provenir de l'étape de gravure b), de remplissage c), de polissage d), ou encore d'autres étapes technologiques réalisées sur tout ou partie de la couche mixte avant le dépôt de cette couche de planarisation et notamment des étapes visant à réaliser des composants, ultérieurement enterrés.

Le procédé illustré sur les figures 1 à 8 et présenté précédemment dans ses grandes étapes va être détaillé sur un exemple non limitatif permettant la réalisation d'un SOI partiel.

### a) fabrication d'un substrat comportant une couche sacrificielle (figure 1).

Cette étape vise dans cet exemple détaillé à réaliser un substrat de type SOI comportant entre la couche d'oxyde enterrée et le film mince de silicium une couche de nitrure (couche sacrificielle). Un dépôt de nitrure de silicium (Si₃N₄) repéré 2 est réalisé sur un substrat préliminaire de silicium massif (ici située en partie supérieure dont on voit une partie 1), avantageusement monocristallin. Cette couche de nitrure jouera le rôle de couche sacrificielle dans la suite du procédé. Plusieurs techniques de dépôt sont connues à cet effet (LPCVD, CVD etc.). En ce qui concerne la présente application, le dépôt LPCVD (Low Pressure Chemical Vapour Déposition) est préféré comme étant le mieux adapté. Le substrat préliminaire fait ensuite l'objet d'une implantation par des ions ou des espèces gazeuses de façon à créer une zone fragile enterrée délimitant dans cette plaquette la couche mince préliminaire 1. Les conditions d'implantations varient en fonction de l'épaisseur de la couche de nitrure et en fonction de l'épaisseur souhaitée du silicium ; les doses d'implantation varient par exemple de quelques 10¹⁶ à quelques 10¹⁷ atomes par cm², l'énergie de 30keV à 200keV. En variante, il est possible de procéder à l'étape d'implantation avant le dépôt de la couche sacrificielle.

Par ailleurs, une couche isolante 3, ici d'oxyde (oxyde thermique ou oxyde déposé), est formée sur un substrat 4 dit support de substrat de départ (ici situé en partie inférieure) pour former un substrat de départ. En variante, il serait possible de former cette couche d'oxyde pour tout ou partie sur la couche de nitrure de la première plaquette. Les surfaces à assembler des couches 2 et 3 sont ensuite préparées en vue de leur collage (notamment par un nettoyage chimique approprié). Elles sont ensuite collées par mise en contact intime. Un recuit à haute température permet de renforcer le collage entre les couches 2 et 3 et fracturer le substrat préliminaire le long de sa zone fragile enterrée en sorte d'isoler la couche préliminaire 1 vis-à-vis du reste de ce substrat préliminaire. La surface de la structure SOI ainsi obtenue est rugueuse après la fracture (surface supérieure de la figure 1). Les procédés de finition habituels (y compris le polissage CMP ou les traitements thermiques sous diverses atmosphères (par exemple un recuit sous hydrogène pour le lissage du silicium)) permettent d'obtenir la rugosité finale voulue, typiquement de quelques dixièmes de nanomètres rms.

### b) lithographie et gravure sélective de la couche préliminaire (figure 2)

Lors de cette étape, bien connue en soi, une résine photosensible (non représentée) est étalée sur le substrat (sur la surface supérieure obtenue à la figure 1). Cette résine est ensuite insolée en utilisant un équipement approprié à travers un masque qui contient le pattern ou dessin souhaité. Après le développement de la résine, une gravure chimique ou/et sèche (gravure assistée par plasma, par exemple) permet de graver le matériau de la couche préliminaire 1, dans l'exemple en silicium, de manière sélective par rapport au nitrure de silicium de la couche sacrificielle 2. Une gravure dans une solution de TMAH pourra par exemple être réalisée. En effet, la vitesse de gravure dans une solution de TMAH (c'est-à-dire, tétra méthyl ammonium hydroxyde) est de 2 nm/mn pour le nitrure de silicium alors qu'elle varie entre 0.4 et 0.5 µm/mn pour du silicium (d'orientation cristalline <1 0 0>). On obtient ainsi des plots d'intérêt 1A, 1B, 1C,... de silicium, avantageusement monocristallin.

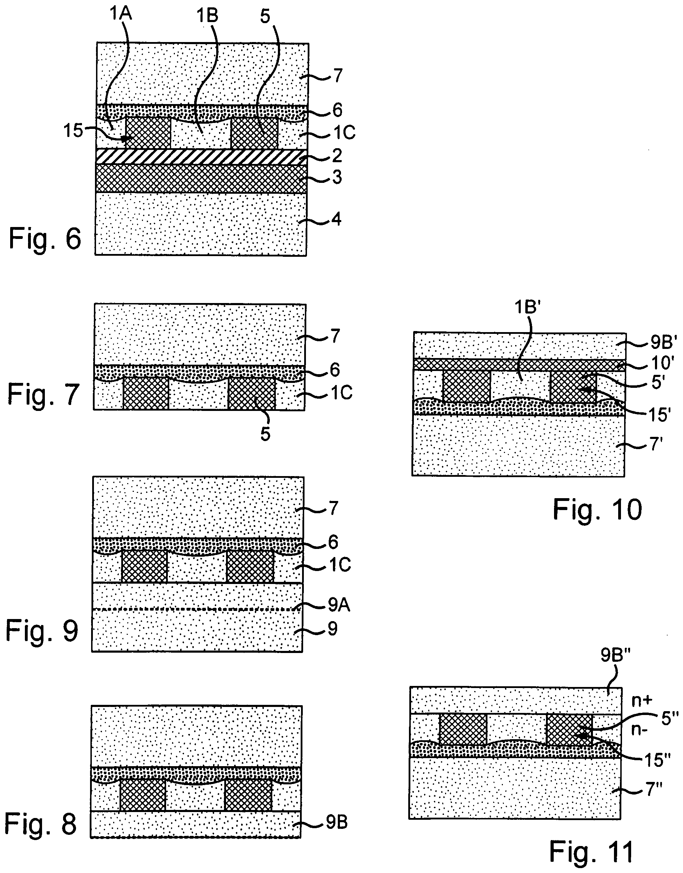

Il est également possible, à ce niveau, de modifier les propriétés de la couche de silicium en terme de dopage par exemple (voir la figure 11).

### c) remplissage des zones de surfaces situées entre les plots d'intérêt (figure 3)

Toutes les techniques connues de dépôt peuvent être considérées ici.

Ce remplissage pourra être réalisé par dépôt d'un matériau avantageusement isolant, par exemple de l'oxyde de silicium. Ce matériau pourra avantageusement, notamment s'il est prévu à l'étape g) d'enlever la couche sacrificielle 2 par gravure, présenter une sélectivité de gravure suffisante par rapport à la couche sacrificielle au niveau de son interface avec cette couche. Ce dépôt 5 est effectué jusqu'à remplir les espaces entre les plots 1A à 1C.

### d) polissage (figure 4)

En fonction du matériau déposé auparavant, on peut appliquer des conditions de polissage convenables. Le polissage est effectué au moins jusqu'à mettre à nu les plots 1A, 1B et 1C.

Comme cela a été décrit précédemment, ce polissage fait apparaître des dénivellations. Elles sont exagérées à la figure 4 mais, ainsi que cela ressortira plus loin, ces dénivellations ne sont pas gênantes pour la réalisation de la structure finale. Les plots 1A, 1B et 1C après polissage forment en fait des premiers motifs, dans cet exemple non isolants, définissant, conjointement avec les second motifs formés par les restes de la couche 5 (notés en conséquence motifs 5), dans cet exemple isolants, une couche mixte notée 15.

### e) dépôt sur la couche mixte d'une couche mince de planarisation (figure 5)

La surface polie obtenue à la fin de l'étape représentée par la figure 4, avec des dénivellations, est recouverte d'une couche de planarisation 6 par toute technique connue appropriée. Il peut s'agir avantageusement, par exemple d'une couche de silicium polycristallin qui peut être obtenue par dépôt CVD ou LPCVD par exemple, ou d'une couche métallique obtenue par une technique d'évaporation ou de pulvérisation. Un procédé standard de polissage est ensuite appliqué à cette couche homogène de polysilicium (silicium polycristallin) ou de métal pour la rendre compatible avec un collage (étape suivante).

### f) collage sur la couche de planarisation d'un substrat de support (figure 6)

L'assemblage d'une plaque additionnelle 7 appelée substrat de support, par exemple de silicium, à l'ensemble de la figure 5 peut-être obtenu grâce à un collage direct après une étape préalable facultative de préparation des surfaces à assembler (pouvant inclure des étapes de polissage de type CMP, de nettoyage dans des solutions chimiques connues appropriées de façon notamment à activer chimiquement les surfaces).

Un traitement thermique de renforcement du collage direct peut avantageusement être prévu.

### g) élimination du substrat de départ et de la couche sacrificielle (figure 7)

Plusieurs solutions sont possibles à cet effet parmi lesquelles on peut citer les techniques suivantes.

Tout d'abord, le substrat de support de départ 4 peut avoir été précédemment implantée (comme la plaquette ayant abouti à la couche mince préliminaire 1), de sorte qu'un recuit de fracture permet de détacher l'essentiel du substrat 4 de silicium (dès la figure 1 sous réserve d'avoir pu ensuite manipuler l'ensemble des figures 2 à 6 ou ultérieurement). Dans ce cas, la fine couche résiduelle de silicium et la couche d'oxyde 3 peuvent être gravées sélectivement par exemple respectivement dans une solution TMAH et une solution HF. Ensuite la couche de nitrure peut à son tour être gravée par exemple dans une solution d'acide phosphorique (H3PO4) à 120°C.

Si la plaquette n'a pas été implantée, l'enlèvement du substrat de départ peut se faire par amincissement mécanique (« grinding » en anglais) et/ou attaque chimique. Aujourd'hui les équipements d'amincissement permettent d'obtenir une précision d'enlèvement de quelques micromètres pour les plaquettes de silicium de 200 mm de diamètre. Afin de ne pas détériorer la couche de nitrure, l'amincissement mécanique peut avantageusement s'arrêter quelques micromètres au dessus de l'interface avec le nitrure. Comme dans le premier cas, une gravure chimique dans le TMAH et une gravure HF permettent d'enlever le silicium et l'oxyde résiduel. Ensuite la couche de nitrure est gravée dans une solution de H3PO4.

Dans une autre variante, il est possible que le substrat adapté de la figure 1 comporte une zone de démontage pour permettre, associée ou non à une étape de gravure, l'enlèvement du substrat de départ et de la couche sacrificielle par exemple par l'application de forces mécaniques, notamment par l'insertion d'une lame au niveau de cette zone de démontage. Cette zone de démontage peut être obtenue par exemple par la réalisation volontaire et contrôlée d'une interface de collage relativement faible entre la couche sacrificielle et le substrat de départ et/ou entre la couche sacrificielle et la couche préliminaire.

La surface mixte libérée après l'enlèvement de la couche sacrificelle est plane : elle ne présente aucune dénivellation, aucun relief. Elle est compatible en termes de planéité avec un collage direct. Il serait possible à ce stade, si souhaité, de graver une partie de la couche mixte dans la mesure où la méthode de gravure utilisée conserve une planéité de surface compatible avec un collage direct.

### h) report sur la face mise à nu de la couche mixte d'une couche de recouvrement (figure 8)

Une couche de recouvrement 9B, par exemple de silicium peut ensuite être reportée sur la surface mixte mise à nu.

A nouveau, plusieurs techniques sont possibles pour réaliser cette étape.

Par exemple, on peut prévoir de coller par collage direct sur la surface mixte libérée une nouvelle plaquette 9, dit plaquette de recouvrement, en silicium, après une préparation appropriée des faces à assembler. Cette plaquette 9 peut ensuite être amincie pour ne laisser subsister sur la couche mixte que la couche de recouvrement 9B.

Cet amincissement peut être réalisé, par exemple, par polissage mécano-chimique ou, comme illustré figure 9, par fracture le long d'une zone fragile enterrée 9A, préalablement réalisée dans la plaquette 9, par exemple par implantation d'espèces gazeuses (notamment d'hydrogène). On conserve ainsi une couche 9B de la plaquette 9, formant la couche de recouvrement, dont l'épaisseur est très bien contrôlée.

En reportant la couche de recouvrement 9B de silicium, on obtient un SOI partiel avec des zones contenant des motifs d'isolant (de SiO2 par exemple) et des zones dépourvues d'isolant, avantageusement en matériau monocristallin, par exemple en silicium (tout à fait appropriées pour la formation de composants verticaux).

Si la couche de recouvrement 9B de silicium comporte au niveau de son interface avec la couche mixte une couche isolante d'interface, par exemple d'oxyde, avantageusement un oxyde thermique, on obtient un SOI mixte avec différentes épaisseurs de matériau isolant enterré. Une telle structure SOI mixte est représentée à la figure 10, la couche isolante d'interface portant la référence 10' (sur cette figure 10, les références désignant des éléments analogues à ceux de la figure 8 découlant des références de cette figure 8 par addition de l'indice « prime »).

### Avantages par rapport aux solutions antérieures :

Le polissage des zones mixtes, par exemple Si/SiO2, ayant lieu sur la face de la couche mixte opposée à celle en contact avec la couche de recouvrement 9B, n'a aucun impact sur la qualité du collage existant entre les motifs d'isolant 5 et la couche de recouvrement 9B. Les conditions de polissage peuvent en conséquence rester les mêmes pour toute la gamme des épaisseurs et des tailles de plots d'oxyde 5.

On peut même choisir des conditions de polissage (abrasifs et tissus de polissage) conduisant à une sélectivité Si/SiO2 importante et se servir des couches d'oxyde comme des couches d'arrêt de polissage.

L'invention permet de réaliser une couche mixte présentant des zones monocristallines. Ces zones peuvent avantageusement être utilisées, étant données leurs propriétés mécaniques et/ou physiques et/ou chimiques, par exemple pour la réalisation de piliers pour des structures suspendues réalisées dans la couche de recouvrement 9B (application MEMS par exemple).

Il est connu que la fabrication par collage d'un substrat SOI avec un oxyde enterré fin est difficile, parce que les impuretés présentes à l'interface de collage ne peuvent pas être toutes adsorbées par la couche fine d'oxyde. Dans la configuration du SOI mixte (voir la figure 10 précitée), il est possible d'utiliser deux oxydes différents. Le premier oxyde 10', thermique, assure les propriétés électriques, tandis que des pavés d'oxydes 5' peuvent être en oxyde déposé de plus faible densité. On peut alors prévoir que les impuretés présentes à l'interface de collage seront adsorbées par les pavés d'oxyde comme indiqué dans le document WO - 2004/059711 précité.

La couche de recouvrement 9B", par exemple en silicium, peut avoir une orientation cristalline ou un dopage différent des pavés de silicium 1A, 1B, etc. situés entre les motifs d'isolant 5. L'interface de collage est proche de la surface. Il est donc possible (voir la figure 11 où les éléments similaires à ceux de la figure 8 sont désignés par des références qui se déduisent des références de cette figure 8 par addition de l'indice « seconde ») d'intégrer une couche de silicium dopée n+ directement sur les pavés de silicium n- (ou inversement). Dans cette configuration certains composants peuvent êtres réalisés sans modification du dopage lors de la fabrication (application à la réalisation de diode, notamment).

Les pavés de silicium sont de qualité cristalline et les composants (non représentés) peuvent être réalisés directement sur cette partie du silicium. En plus, la couche de recouvrement de silicium peut avoir une orientation cristalline différente de celle des pavés d'oxyde (technologie dite HOT pour Hybrid Orientation Technology).

Il est tout à fait possible d'employer différents matériaux et de réaliser différentes configurations (épaisseurs, taille de plots) sans modifier les paramètres de procédé de façon significative.

La couche de polysilicium 6 peut être remplacée par une couche métallique pour certaines applications (notamment pour favoriser une bonne dissipation thermique). Pour les circuits ou les composants réalisés sur les zones SOI (Si/SiO2) la couche métallique permet de limiter l'effet de pénétration des lignes de champs dans le substrat (« ground plane »). Le principe de plan de masse est de placer une équipotentielle sous l'oxyde enterré.

Si le substrat de support 7 présente en surface au moins une couche de silicium, le matériau de la couche de planarisation 6 peut avantageusement être choisi en sorte de former, à la suite d'un traitement thermique approprié (dit de siliciuration) un alliage avec tout ou partie de ce silicium de surface, favorisant ainsi notamment l'adhérence entre la couche de planarisation et le substrat support.

Tous les transferts de couches sont compatibles avec le procédé « Smart Cut »TM. Il y a donc le moyen de recycler chaque plaquette de silicium pour les consommer progressivement, couche par couche.

Tous les collages directs peuvent être réalisés sur les mêmes équipements.

Il faut noter que les défauts de polissage sont, selon l'invention, recouverts d'une couche qui, après polissage, est collée de manière directe à un substrat, comme dans le document US - 5 691 231 précité. Toutefois, il faut bien comprendre que la qualité de ce collage et le fait que les tranches des motifs d'oxyde puissent être ici imparfaitement coplanaires a bien moins d'importance qu'au niveau de l'interface de collage 1C+5/10 à la figure 10, car cet interface de collage est bien plus proche de la surface libre de l'ensemble de la structure mixte obtenue.

Le cas précité met principalement en oeuvre des couches homogènes (couche de planarisation, substrat support, couche de remplissage, couche de recouvrement...) mais il est clair que toutes ces couches peuvent être composées d'un empilement de plusieurs matériaux différents (en termes de composition et/ou de dopage et/ou d'orientation cristalline...) voire localisées et différentes suivant les zones d'une même surface.

Le cas précité utilise principalement du silicium pour les diverses couches ou motifs (éventuellement sous formes d'oxydes ou de nitrures) mais l'un des intérêts de l'invention est de pouvoir employer différents matériaux pour réaliser la couche mixte, notamment des matériaux isolants choisis parmi SiO2 thermique et/ou déposé, Si3N4, Al2O3, AIN, SiC et d'autres matériaux isolants, associés à des matériaux non isolants, avantageusement monocristallins, comme du silicium dopé, du silicium germanium, du germanium, des matériaux (III-V) (InP, GaAs, GaN,...) ...

Il est également possible d'utiliser divers matériaux pour la couche de planarisation notamment des métaux choisis parmi Ni, Pd, Co, Pt, W et/ou des alliages de ces métaux par exemple avec du silicium.

L'invention peut être avantageusement mise en oeuvre pour tirer profit des propriétés électriques mixtes de la structure obtenue. Elle peut être également utilisée pour tirer profit de la mixité des propriétés chimiques et/ou mécaniques et/ou optiques et/ou thermiques obtenues au sein de la couche mixte...

Elle permet d'utiliser une grande variété de matériaux de part et d'autre de la couche mixte. A titre indicatif, on pourra citer des matériaux semiconducteurs comme le silicium mais aussi SiGe, GaAs, GaN, InP et d'autres matériaux des groupes (III-V) ou (II-VI) ou encore des matériaux isolants comme SiO2, Si3N4, Al2O3, AIN. Comme déjà mentionné, ces couches pourront être composites. On pourra, par exemple pour des applications en photonique, prévoir de disposer de part et d'autre de la couche mixte des empilements formant miroirs par exemple en bicouches (SiO2, Si3N4) ou (SiO2, Si)...

## Revendications

1. Procédé de fabrication d'une structure micro-technologique mixte, selon lequel :
a) on réalise un substrat provisoire comportant une couche sacrificielle (2), puis
b) on forme, sur la couche sacrificielle, une couche mixte (15, 15', 15") comportant au moins de premiers motifs en un premier matériau (1A, 1B, 1C) et de seconds motifs en un deuxième matériau (5) différent du premier matériau, ces premiers et seconds motifs étant adjacents à la couche sacrificielle, puis
c) on enlève cette couche sacrificielle en sorte de mettre à nu une surface mixte de ladite couche mixte, cette surface mixte comportant des portions des premiers motifs et des portions des deuxièmes motifs, puis
d) on réalise sur cette surface mixte, par collage direct, une couche continue de recouvrement (9B, 9B', 9B") en un troisième matériau.

2. Procédé selon la revendication 1, **caractérisé en ce que** l'un au moins des premier et deuxième matériaux est monocristallin.

3. Procédé selon la revendication 1 ou la revendication 2, **caractérisé en ce que** le premier matériau est électriquement non isolant.

4. Procédé selon l'une quelconque des revendications 1 à 3, **caractérisé en ce que** le second matériau est électriquement isolant.

5. Procédé selon l'une quelconque des revendications 1 à 4, **caractérisé en ce que** le troisième matériau est électriquement non isolant.

6. Procédé selon l'une quelconque des revendications 1 à 5, **caractérisé en ce que** les premiers motifs non isolants et la couche continue de recouvrement contiennent un même élément.

7. Procédé selon la revendication 6, **caractérisé en ce que** ce même matériau est du silicium.

8. Procédé selon l'une quelconque des revendications 1 à 7, **caractérisé en ce que** la couche continue de recouvrement et les premiers motifs contiennent des dopages différents.

9. Procédé selon l'une quelconque des revendications 1 à 8, **caractérisé en ce que** les seconds motifs sont en oxyde.

10. Procédé selon la revendication 9, **caractérisé en ce que** les seconds motifs contiennent un oxyde d'un élément contenu dans les premiers motifs.

11. Procédé selon la revendication 10, **caractérisé en ce que** cet oxyde est un oxyde de silicium.

12. Procédé selon l'une quelconque des revendications 1 à 11, **caractérisé en ce que** la couche sacrificielle est un nitrure.

13. Procédé selon la revendication 11, **caractérisé en ce que** la couche sacrificielle et les seconds motifs comportent respectivement un nitrure et un oxyde d'un même élément que comportent les premiers motifs de la couche mixte.

14. Procédé selon l'une quelconque des revendications 1 à 13, **caractérisé en ce que** la couche de recouvrement est en un même matériau que les premiers motifs.

15. Procédé selon l'une quelconque des revendications 1 à 14, **caractérisé en ce que** les premiers motifs sont en silicium.

16. Procédé selon l'une quelconque des revendications 1 à 15, **caractérisé en ce que**, avant de réaliser la couche continue de recouvrement sur la surface mixte, on forme sur cette surface mixte ou sur cette couche continue de recouvrement une couche isolante d'interface.

17. Procédé selon la revendication 16, **caractérisé en ce que** l'on forme la couche isolante d'interface par oxydation de surface de la couche continue de recouvrement.

18. Procédé selon la revendication 16 ou la revendication 17, **caractérisé en ce que** la couche isolante d'interface et les seconds motifs sont formés d'oxydes d'un même élément.

19. Procédé selon la revendication 18, **caractérisé en ce que** les premiers motifs sont en silicium et les oxydes de la couche isolante d'interface et des seconds motifs sont en oxydes de silicium.

20. Procédé selon l'une quelconque des revendications 1 à 19, **caractérisé en ce qu'**on réalise ledit substrat provisoire à partir d'un substrat de départ comportant la couche sacrificielle (2) et une couche préliminaire continue (1) formée du premier matériau selon les étapes suivantes :
- on creuse par lithographie des cavités dans cette couche préliminaire à partir d'une face de cette couche qui est opposée à la couche sacrificielle (2), ces cavités s'étendant jusqu'à la couche sacrificielle,
- on remplit ces cavités avec un second matériau en sorte de former les seconds motifs (5) et d'obtenir une surface mixte, cette couche préliminaire étant devenue ladite couche mixte,
- on forme sur cette surface mixte une couche de matériau de planarisation (6),
- on polit cette couche de matériau de planarisation (6) en sorte d'avoir une surface continue plane, et
- on assemble à cette couche préliminaire, recouverte de ladite couche de planarisation, un substrat de support (7, 7', 7") en un quatrième matériau, ce substrat de support ayant une surface collée par collage direct à la surface continue plane de la couche de planarisation.

21. Procédé selon la revendication 20, **caractérisé en ce que** le substrat de départ comporte en outre un substrat de support intermédiaire (4).

22. Procédé selon la revendication 21, **caractérisé en ce que** le substrat de départ comporte en outre une couche isolante entre le substrat de support intermédiaire et la couche sacrificielle.

23. Procédé selon la revendication 22, **caractérisé en ce que** cette couche isolante est en un oxyde d'un élément du substrat de support intermédiaire.

24. Procédé selon l'une quelconque des revendications 21 à 23, **caractérisé par** une étape d'implantation de ce substrat de support intermédiaire avec des ions ou des espèces gazeuses en vue de former dans ce substrat de support intermédiaire une couche fragilisée (9A) le long d'une couche parallèle à la couche sacrificielle.

25. Procédé selon la revendication 24, **caractérisé en ce que**, après assemblage par collage du substrat de support final (7, 7', 7") avec la couche préliminaire, on provoque la séparation du substrat de support intermédiaire le long de la couche fragilisée.

26. Procédé selon l'une quelconque des revendications 20 à 25, **caractérisé en ce que** la couche préliminaire continue (1) est obtenue par collage sur la couche sacrificielle d'un substrat préliminaire dont on provoque la séparation le long d'une couche de fragilisation.

27. Procédé selon l'une quelconque des revendications 20 à 26, **caractérisé en ce que** l'on remplit les cavités par dépôt sous forme vapeur.

28. Procédé selon l'une quelconque des revendications 20 à 27, **caractérisé en ce qu'**on obtient la surface mixte en polissant ce second matériau jusqu'à mettre à nu des portions de cette couche préliminaire entre les cavités,

29. Procédé selon l'une quelconque des revendications 20 à 28, **caractérisé en ce que** la couche de planarisation (6) est une couche polycristalline d'un matériau que comporte les premiers motifs.

30. Procédé selon la revendication 29, caractérisé en ce cette couche polycristalline est déposée sous forme vapeur.

31. Procédé selon l'une quelconque des revendications 20 à 28, **caractérisé en ce que** la couche de planarisation (6) est une couche métallique.

32. Procédé selon la revendication 31, **caractérisé en ce que** la couche métallique est déposée par une technique d'évaporation ou de pulvérisation ou de dépôt en phase vapeur.

33. Procédé selon l'une quelconque des revendications 20 à 32, **caractérisé en ce que** le substrat de support final est en un matériau que comportent les premiers motifs.

## Patentansprüche

1. Verfahren zur Herstellung einer gemischten mikrotechnologischen Struktur, bei dem:
a) ein provisorisches Substrat hergestellt wird, umfassend eine Opferschicht (2), dann
b) auf der Opferschicht eine gemischte Schicht (15, 15', 15") gebildet wird, umfassend mindestens erste Motive aus einem ersten Material (1A, 1B, 1C) und zweite Motive aus einem zweiten Material (5), das zum ersten Material unterschiedlich ist, wobei diese ersten und zweiten Motive an die Opferschicht angrenzen, dann
c) Entfernen dieser Opferschicht, um eine gemischte Oberfläche der gemischten Schicht freizulegen, wobei diese gemischte Oberfläche Abschnitte der ersten Motive und Abschnitte der zweiten Motive umfasst, dann
d) auf dieser gemischte Schicht Herstellen einer durchgehenden Abdeckungsschicht (9B, 9B', 9B") aus einem dritten Material durch direktes Ankleben.

2. Verfahren nach Anspruch 1, **dadurch gekennzeichnet, dass** mindestens eines der ersten und zweiten Materialien mikrokristallin ist.

3. Verfahren nach Anspruch 1 oder Anspruch 2, **dadurch gekennzeichnet, dass** das erste Material elektrisch nicht isolierend ist.

4. Verfahren nach einem der Ansprüche 1 bis 3, **dadurch gekennzeichnet, dass** das zweite Material elektrisch isolierend ist.

5. Verfahren nach einem der Ansprüche 1 bis 4, **dadurch gekennzeichnet, dass** das dritte Material elektrisch nicht isolierend ist.

6. Verfahren nach einem der Ansprüche 1 bis 5, **dadurch gekennzeichnet, dass** ersten nicht isolierenden Motive und die durchgehende Abdeckungsschicht ein selbes Element enthalten.

7. Verfahren nach Anspruch 6, **dadurch gekennzeichnet, dass** dieses selbe Material Silizium ist.

8. Verfahren nach einem der Ansprüche 1 bis 7, **dadurch gekennzeichnet, dass** die durchgehende Abdeckungsschicht und die ersten Motive unterschiedliche Dotierungen enthalten.

9. Verfahren nach einem der Ansprüche 1 bis 8, **dadurch gekennzeichnet, dass** die zweiten Motive aus Oxid sind.

10. Verfahren nach Anspruch 9, **dadurch gekennzeichnet, dass** die zweiten Motive ein Oxid eines Elements enthalten, das in den ersten Motiven enthalten ist.

11. Verfahren nach Anspruch 10, **dadurch gekennzeichnet, dass** dieses Oxid ein Siliziumoxid ist.

12. Verfahren nach einem der Ansprüche 1 bis 11, **dadurch gekennzeichnet, dass** die Opferschicht aus Nitrid ist.

13. Verfahren nach Anspruch 11, **dadurch gekennzeichnet, dass** die Opferschicht und die zweiten Motive jeweils ein Nitrid und ein Oxid eines selben Elements, das die ersten Motive der gemischten Schicht umfassen, enthalten.

14. Verfahren nach einem der Ansprüche 1 bis 13, **dadurch gekennzeichnet, dass** die Abdeckungsschicht aus einem selben Material wie die ersten Motive ist.

15. Verfahren nach einem der Ansprüche 1 bis 14, **dadurch gekennzeichnet, dass** die ersten Motive aus Silizium sind.

16. Verfahren nach einem der Ansprüche 1 bis 15, **dadurch gekennzeichnet, dass** vor der Herstellung der durchgehenden Abdeckungsschicht auf der gemischten Oberfläche auf dieser gemischten Oberfläche oder auf dieser durchgehenden Abdeckungsschicht eine Grenzisolierschicht gebildet wird.

17. Verfahren nach Anspruch 16, **dadurch gekennzeichnet, dass** die Grenzisolierschicht durch Oberflächenoxydation der durchgehenden Abdeckungsschicht gebildet wird.

18. Verfahren nach Anspruch 16 oder Anspruch 17, **dadurch gekennzeichnet, dass** die Grenzisolierschicht und die zweiten Motive von Oxiden eines selben Elements gebildet sind.

19. Verfahren nach Anspruch 18, **dadurch gekennzeichnet, dass** die ersten Motive aus Silizium sind, und die Oxide der Grenzisolierschicht und der zweiten Motive aus Siliziumoxiden sind.

20. Verfahren nach einem der Ansprüche 1 bis 19, **dadurch gekennzeichnet, dass** das provisorische Substrat aus einem Ausgangssubstrat hergestellt wird, umfassend die Opferschicht (2) und eine durchgehende Vorschicht (1), die aus dem ersten Material nach den folgenden Schritten gebildet wird:
- Aushöhlen von Hohlräumen in dieser Vorschicht durch Lithografie, ausgehend von einer Seite dieser Schicht, die der Opferschicht (2) gegenüberliegt, wobei sich diese Hohlräume bis zur Opferschicht erstrecken,
- Füllen dieser Hohlräume mit einem zweiten Material, um die zweiten Motive (5) zu bilden und eine gemischte Oberfläche zu erhalten, wobei diese Vorschicht die gemischte Schicht geworden ist,
- auf dieser gemischten Oberfläche Bilden einer Schicht aus planarisierendem Material (6),
- Polieren dieser Schicht aus planarisierendem Material (6), um eine plane durchgehende Oberfläche zu erhalten, und
- Verbinden mit dieser Vorschicht, die mit der planarisierenden Schicht bedeckt ist, eines Trägersubstrats (7, 7', 7") aus einem vierten Material, wobei dieses Trägersubstrat eine Oberfläche hat, die durch direktes Ankleben an der planen durchgehenden Oberfläche der planarisierenden Schicht angeklebt wird.

21. Verfahren nach Anspruch 20, **dadurch gekennzeichnet, dass** das Ausgangssubstrat ferner ein Zwischenträgersubstrat (4) umfasst.

22. Verfahren nach Anspruch 21, **dadurch gekennzeichnet, dass** das Ausgangssubstrat ferner eine Isolierschicht zwischen dem Zwischenträgersubstrat und der Opferschicht umfasst.

23. Verfahren nach Anspruch 22, **dadurch gekennzeichnet, dass** diese Isolierschicht ein Oxid eines Elements des Zwischenträgersubstrats ist.

24. Verfahren nach einem der Ansprüche 21 bis 23, **gekennzeichnet durch** einen Implantationsschritt dieses Zwischenträgersubstrats mit Ionen oder gasförmigen Gattungen, um in diesem Zwischenträgersubstrat eine fragilisierte Schicht (9A) entlang einer Schicht parallel zur Opferschicht zu bilden.

25. Verfahren nach Anspruch 24, **dadurch gekennzeichnet, dass** nach dem Zusammenfügen des endgültigen Trägersubstrats (7, 7', 7") mit der Vorschicht durch Kleben die Trennung des Zwischenträgersubstrats entlang der fragilisierten Schicht hervorgerufen wird.

26. Verfahren nach einem der Ansprüche 20 bis 25, **dadurch gekennzeichnet, dass** die durchgehende Vorschicht (1) durch Kleben eines Vorsubstrats, dessen Trennung entlang einer Fragilisierungsschicht hervorgerufen wird, auf die Opferschicht erhalten wird.

27. Verfahren nach einem der Ansprüche 20 bis 26, **dadurch gekennzeichnet, dass** die Hohlräume durch Dampfabscheidung gefüllt werden.

28. Verfahren nach einem der Ansprüche 20 bis 27, **dadurch gekennzeichnet, dass** die gemischte Oberfläche durch Polieren dieses zweiten Materials, bis Abschnitte dieser Vorschicht zwischen den Hohlräumen freigelegt werden, erhalten wird.

29. Verfahren nach einem der Ansprüche 20 bis 28, **dadurch gekennzeichnet, dass** die planarisierende Schicht (6) eine polykristalline Schicht aus einem Material, das die ersten Motive umfassen, ist.

30. Verfahren nach Anspruch 29, **dadurch gekennzeichnet, dass** diese polykristalline Schicht in Dampfform abgeschieden wird.

31. Verfahren nach einem der Ansprüche 20 bis 28, **dadurch gekennzeichnet, dass** die planarisierende Schicht (6) eine metallische Schicht ist.

32. Verfahren nach Anspruch 31, **dadurch gekennzeichnet, dass** die metallische Schicht durch eine Verdampfungs- oder Zerstäubungs- oder Dampfabscheidungstechnik aufgebracht wird.

33. Verfahren nach einem der Ansprüche 20 bis 32, **dadurch gekennzeichnet, dass** das endgültige Trägersubstrat ein Material, das die ersten Motive umfassen, ist.

## Claims

1. Method of fabricating a mixed microtechnology structure, according to which:
a) a temporary substrate comprising a sacrificial layer (2) is produced, then
b) on the sacrificial layer, a mixed layer (15, 15', 15") comprising at least first patterns made of a first material (1A, 1B, 1C) and second patterns made of a second material (5) different from the first material is formed, these first and second patterns being adjacent to the sacrificial layer, then
c) this sacrificial layer is removed so as to expose a mixed surface of said mixed layer, said mixed surface comprising portions of the first patterns and portions of the second patterns, then
d) a continuous covering layer (9B, 9B', 9B") made of a third material is produced on this mixed surface by direct bonding.

2. Method according to Claim 1, **characterized in that** at least one of the first and second materials is monocrystalline.

3. Method according to Claim 1 or Claim 2, **characterized in that** the first material is not electrically insulating.

4. Method according to any one of Claims 1 to 3, **characterized in that** the second material is electrically insulating.

5. Method according to any one of Claims 1 to 4, **characterized in that** the third material is not electrically insulating.

6. Method according to any one of Claims 1 to 5, **characterized in that** the non-insulating first patterns and the continuous covering layer contain the same element.

7. Method according to Claim 6, **characterized in that** this same material is silicon.

8. Method according to any one of Claims 1 to 7, **characterized in that** the continuous covering layer and the first patterns contain different dopings.

9. Method according to any one of Claims 1 to 8, **characterized in that** the second patterns are made of oxide.

10. Method according to Claim 9, **characterized in that** the second patterns contain an oxide of an element contained in the first patterns.

11. Method according to Claim 10, **characterized in that** this oxide is a silicon oxide.

12. Method according to any one of Claims 1 to 11, **characterized in that** the sacrificial layer is a nitride.

13. Method according to Claim 11, **characterized in that** the sacrificial layer and the second patterns respectively comprise a nitride and an oxide of the same element that the first patterns of the mixed layer comprise.

14. Method according to any one of Claims 1 to 13, **characterized in that** the covering layer is made of the same material as the first patterns.

15. Method according to any one of Claims 1 to 14, **characterized in that** the first patterns are made of silicon.

16. Method according to any one of Claims 1 to 15, **characterized in that**, before producing the continuous covering layer on the mixed surface, an insulating interface layer is formed on this mixed surface or on this continuous covering layer.

17. Method according to Claim 16, **characterized in that** the insulating interface layer is formed by surface oxidation of the continuous covering layer.

18. Method according to Claim 16 or Claim 17, **characterized in that** the insulating interface layer and the second patterns are formed of oxides of the same element.

19. Method according to Claim 18, **characterized in that** the first patterns are made of silicon and the oxides of the insulating interface layer and of the second patterns are made of silicon oxides.

20. Method according to any one of Claims 1 to 19, **characterized in that** said temporary substrate is produced from a starting substrate comprising the sacrificial layer (2) and a continuous preliminary layer (1) formed of the first material, according to the following steps:
- hollowing cavities lithographically in this preliminary layer starting from a face of this layer that is opposite the sacrificial layer (2), these cavities extending as far as the sacrificial layer,
- filling these cavities with a second material so as to form the second patterns (5) and to obtain a mixed surface, this preliminary layer having become said mixed layer,
- forming a layer of planarization material (6) on this mixed surface;
- polishing this layer of planarization material (6) so as to have a continuous planar surface, and
- assembling a support substrate (7, 7', 7") made of a fourth material to this preliminary layer, covered with said planarization layer, this support substrate having a surface bonded by direct bonding to the continuous planar surface of the planarization layer.

21. Method according to Claim 20, **characterized in that** the starting substrate further comprises an intermediate support substrate (4).

22. Method according to Claim 21, **characterized in that** the starting substrate further comprises an insulating layer between the intermediate support substrate and the sacrificial layer.

23. Method according to Claim 22, **characterized in that** this insulating layer is made of an oxide of an element of the intermediate support substrate.

24. Method according to any one of Claims 21 to 23, **characterized by** a step of implanting this intermediate support substrate with gaseous species or ions with a view to forming, in this intermediate support substrate, a weakened layer (9A) along a layer parallel to the sacrificial layer.

25. Method according to Claim 24, **characterized in that**, after assemby by bonding of the final support substrate (7, 7', 7") with the preliminary layer, the separation of the intermediate support substrate along the weakened layer is brought about.

26. Method according to any one of Claims 20 to 25, **characterized in that** the continuous preliminary layer (1) is obtained by bonding to the sacrificial layer a preliminary substrate, the separation of which along a weakened layer is brought about.

27. Method according to any one of Claims 20 to 26, **characterized in that** the cavities are filled by vapour deposition.

28. Method according to any one of Claims 20 to 27, **characterized in that** the mixed surface is obtained by polishing this second material until portions of this preliminary layer are exposed between the cavities.

29. Method according to any one of Claims 20 to 28, **characterized in that** the planarization layer (6) is a polycrystalline layer of a material that the first patterns comprise.

30. Method according to Claim 29, **characterized in that** this polycrystalline layer is deposited in vapour form.

31. Method according to any one of Claims 20 to 28, **characterized in that** the planarization layer (6) is a metallic layer.

32. Method according to Claim 31, **characterized in that** the metallic layer is deposited by an evaporation or spraying or vapour deposition technique.

33. Method according to any one of Claims 20 to 32, **characterized in that** the final support substrate is made of a material that the first patterns comprise.
